# EUROPEAN PATENT APPLICATION

(11) **EP 4 194 951 A1**
(43) Date of publication of application: **14.06.2023**
(21) Application number: 21214040.4
(22) Date of filing: 13.12.2021
(51) Int. Cl.: G03F 7/20, G06N 20/00

(54) **IDENTIFYING DEVIATING MODULES FROM A REFERENCE POPULATION FOR MACHINE DIAGNOSTICS**

(71) Applicant: ASML Netherlands B.V., 5500 AH Veldhoven (NL)
(72) Inventor: DOUNAEV, Dimitriy, 5500 AH Veldhoven (NL); GKOROU, Dimitra, 5500 AH Veldhoven (NL); VAN HERTUM, Pieter, 5500 AH Veldhoven (NL); LIJFFIJT, Jefrey, 5500 AH Veldhoven (NL); VAN SHOUBROECK, Joachim Kinley, 5500 AH Veldhoven (NL); KAREVAN, Zahra, 5500 AH Veldhoven (NL); YPMA, Alexander, 5500 AH Veldhoven (NL)
(74) Representative: ASML Netherlands B.V.

(57) **Abstract**

A fault in a subject production apparatus which is suspected of being a deviating machine, is identified based on whether it is possible to train a machine learning model to distinguish between first sensor data derived from the subject production apparatus, and second sensor data derived from one or more other production apparatuses which are assumed to be behaving normally. Thus, the discriminative ability of the machine learning model is used as an indicator to discriminate between a faulty machine and the population of healthy machines.

## Description

### FIELD

The present invention relates to a method, a computer system, a computer program product, and a computer-readable storage medium for diagnosing a fault in a production apparatus, such as a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k₁ lithography may be used to process features with dimensions smaller than the classical resolution limit of a lithographic apparatus. In such process, the resolution formula may be expressed as CD = k₁×λ/NA, where λ is the wavelength of radiation employed, NA is the numerical aperture of the projection optics in the lithographic apparatus, CD is the "critical dimension" (generally the smallest feature size printed, but in this case half-pitch) and k₁ is an empirical resolution factor. In general, the smaller k₁ the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

A lithographic apparatus typically includes internal sensors which generate signals which allow qualification tests (that is, tests of whether the lithographic apparatus is performing its function properly) to be performed. Further qualification tests may be made based on signals derived from measurements of products of the lithographic apparatus. It would be desirable, when a machine is operating below a desired level of performance, if the signals could be analyzed in order to identify the cause of the machine performance problems, and in particular to identify which module of the lithographic apparatus is causing those problems.

For example, two typical faults which may occur are that a lens or an airmount (a well-known vibration isolation support device) are incorrectly positioned. For the qualification tests, an exposure of two wafers takes place, and during the exposure module-level measurements are made that indicate the performance of each module. For each module, several properties are measured, resulting in a high dimensional measurement.

Unfortunately, when a lithographic apparatus develops a fault, diagnosing that fault is challenging due to the high complexity of the lithographic apparatus. Especially when a fault involves multiple modules and complex interactions between the modules, it is difficult to identify the underlying cause of a problem.

Currently, analyzing the signals for machine diagnostics is a two-step process. Firstly, modules for which the output signals of the sensor deviate from their expected values ("deviating modules") are identified using the output signals. Secondly, a human expert uses domain expertise to assess potential underlying causes for the deviating signals. For example, if the grid plates in both measurement and exposure side deviate, then the expert will suspect that the airmount has an issue.

The first step of this process, identifying deviating modules, is performed in using aggregated statistics per signal e.g., median or mean. The values of these aggregated statistics are compared to corresponding values for a set of healthy machines to identify deviations. Unfortunately, there are several factors which make this process challenging for lithographic apparatus.

First, normally only a small dataset of sensor data is available for investigating potential issues on a faulty machine. There are usually only two exposed wafers from which the sensor data can be obtained.

Also, the sensor data may include important information (particularly time-dependent information such as recurrent signal peaks) which is lost when the aggregated statistical values are calculated.

Additionally, although the comparisons between the sensor data and the values for normal machines are typically performed by assuming that variations in the signals (e.g. within the population of normal machines) are normally distributed, it is known that in fact the sensed values and the corresponding engineered features do not necessarily have normal distributions.

It is also often difficult to identify module abnormality based on context due to noisy information, and there is no fixed definition of what is considered abnormal behavior for a module. In many cases, identifying a faulty module depends on the behavior of its surrounding modules. For example, a deviation of a gridplate on a measurement side might not be an abnormal behavior by itself, but if the measurement of the gridplate on an exposure side exhibits a deviation as well, it can indicate a serious machine issue. In order to capture all potential deviations of a module, a typical diagnostics team collects as much information as possible. However, some of this information can arise as a result of noise influencing the measurements, and is not necessarily indicative of an underlying problem.

Additionally, there is not always a clear explanation of what is causing abnormal behavior, as there are a large number of potential underlying causes such as a faulty screw being used to secure a lens or a misplaced cable. All of these problems can cause machine defects but can result in large or small deviations in the signals of qualification tests. Labelling abnormal behavior is often not possible due to a there being a variety of potential machine issues that rarely occur twice. Even if the same type of problem is present in a machine, it typically manifests itself in a different way on different occasions.

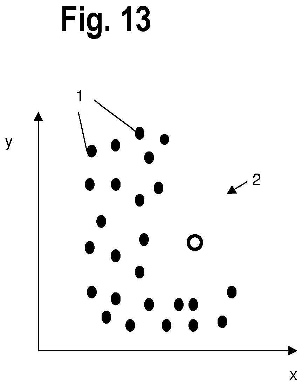

Furthermore, the high-dimensional nature of the signals is conventionally not considered when computing outliers and as a result the identification of module deviations is inaccurate. It can be that a module can deviate from normal population without being an outlier in any of the individual dimensions. This is illustrated in Figure 13. This shows schematically a case in which the sensor data (e.g. for a given module) is composed of data items having two components, *x* and *y*. Data items from the reference population of normal machines are shown as dark circles 1, while the corresponding data item for the subject production apparatus is shown as the circle 2. Although the circle 2 is clearly spaced from the circles 1, indicating that the circle is indeed an outlier (i.e. a deviating machine), it is within the range of x values of the circles 1 and within the range of values of the y values of the circles 1. Furthermore, it is not possible to draw a straight line in the x-y plane which partitions the circles 1 from the circle 2, so the problem cannot be solved by performing the qualification test using a variable which is a linear combination of *x* and *y*.

Finally, with the current technology, it is not always clear how to compare deviating signals from different modules so that deviations of individual modules can be prioritized during diagnostics. For example, it can be difficult to compare a deviation of 50% of a first signal measured from an airmount, and a deviation of 20% measured from first and second lenses. Sometimes this is solvable by using a threshold to determine what signifies a deviation, but through previous work this is known not to be effective in all cases.

For all these reasons, the time taken to identify the underlying problem, while the machine is not operating, can be significant.

### SUMMARY

The present application relates to a method, a computer system, a computer program product, and a computer-readable storage medium which may address at least some of the above-mentioned problems.

In general terms, the invention proposes that a fault in a subject production apparatus which is suspected of being a deviating machine, is identified based on whether it is possible to train a machine learning model to distinguish between first sensor data derived from the subject production apparatus, and second sensor data derived from one or more other production apparatuses which are assumed to be behaving normally. In other words, the discriminative ability of the machine learning model is used as an indicator to discriminate between a faulty machine (or module) and the population of healthy machines.

Specifically, one expression of the present invention is a method of diagnosing a fault in a subject production apparatus, the method comprising: (a) obtaining a first data set and a second data set, wherein the first data set comprises a plurality of features derived from first sensor data measured from the subject production apparatus, and the second data set comprises a plurality of features derived from second sensor data measured from one or more other production apparatuses; (b) performing supervised training of a machine learning model using a first subset of the first data set and a first subset of the second data set, wherein the machine learning model is trained, upon receiving a data item selectively from the first or second datasets, to output a classification value indicative of whether the received data item is from the first or second datasets; (c) inputting a second subset of the first data set and/or a second subset of the second data set to the trained machine learning model to obtain corresponding classification values; (d) evaluating the accuracy of the classification values; and (e) using the evaluated accuracy of the classification values, performing a diagnostic process for determining the presence of a fault in the subject production apparatus. For example, the evaluated accuracy may be a value which is compared with a threshold, and a fault is detected if the value is above the threshold. Alternatively or additionally, the diagnostic process may comprise displaying the evaluated accuracy to an expert.

The method disclosed in the present application provides a more sophisticated way to determine the deviation of the modules of a faulty machine than the known techniques. For example, in the case of sensor data composed of points in a high dimensional space, the partition of the space caused by the machine learning model is more complex than simply one based on threshold values for the individual dimensions, or even one based on a plane defined in that space. In this way, deviating modules can be identified more accurately. Using classification for the identification of deviating modules is advantageous as the nature of deviations is often specific to particular kinds of abnormal activity of modules for the particular machines used.

In a preferred case the method is performed using first sensor data for the subject production apparatus and second sensor data the other production apparatuses derived (only) from one corresponding module of those apparatuses. Then the method is repeated for one or more other modules of the subject production apparatus. Thus, a respective evaluation accuracy is obtained for each respective module of the subject production apparatus. The diagnostic process may include identifying the modules with the highest respective evaluation accuracies, and providing this information to a user.

The diagnostic process may further comprise interrogating the trained machine learning model(s) to determine for each of a plurality of the features a respective importance parameter. The importance parameter is indicative of the importance of the corresponding feature in determining the classification values. For example, if the machine learning model is a logistic regression classifier, the importance parameter may be the magnitude of at least one feature coefficient of the logistic regression classifier (i.e. one or more weight values which are multiplied by a numerical value representing the feature). Alternatively, if the machine learning model is a random forest classifier, the importance value may represent the ability of the given feature to decrease a class impurity of the classification.

The present disclosure also provides a computer system comprising a processor and a data storage device storing program instructions operative, when performed by the processor, to cause the processor to perform the steps of the method described above.

The disclosure further provides a computer program product (such as a computer-readable storage medium) comprising instructions which, when the program is executed by a computer, cause the computer to carry out the steps of the method described above.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically depicts an example computer system in which embodiments can be implemented;
- Figure 5 is a flow diagram of the steps of a method according to the present invention;
- Figure 6 shows schematically the flow of information in an example of the method shown in Figure 5;
- Figure 7 is a screenshot of a first screen generated by a computer system implement a method according to the present invention;
- Figure 8 is a screenshot of a second screen generated by the computer system, including a graph showing importance values for various features according to a trained machine learning model;
- Figure 9 is a screenshot of a third screen generated by the computer system, including a graph showing values at respective times of a feature derived by measurement from a faulty machine and shown to be important by the screenshot of Figure 8, and of the same feature relating to corresponding modules of a plurality of reference machines;
- Figure 10 is a screenshot of a fourth screen generated by the computer system, including a graph showing a combined signal from a combination of features derived from a measurement of a module of a faulty machine, and the combined signal derived from measurements of corresponding modules of a plurality of reference machines;
- Figure 11 shows the distribution of data items comprising two features, where some of the data items are derived from a module the faulty machine and others are derived from the corresponding module of the reference machines;
- Figure 12 shows, for each of two modules of the faulty machine, the distribution of data items comprising two features, where some of the data items are derived from the module the faulty machine and others are derived from the corresponding module of the reference machines;
- Figure 13 illustrates the task of identifying, using sensor data which composed of data items composed of two numerical features, a data item which is an outlier from other data elements.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

### <Reticle>

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

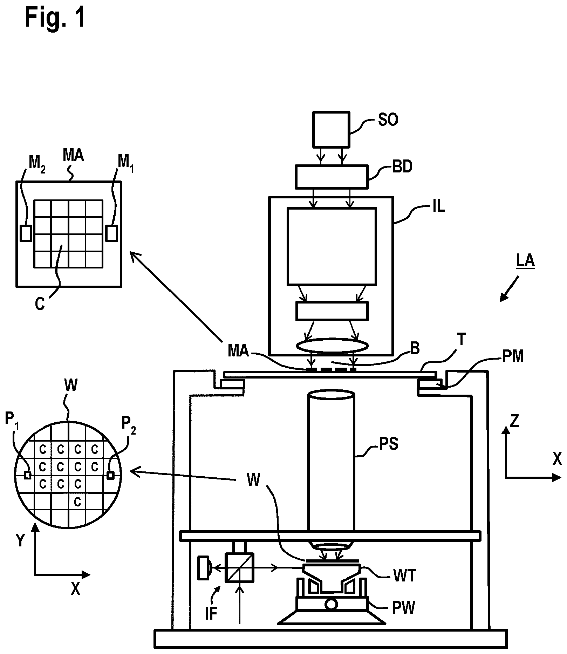

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

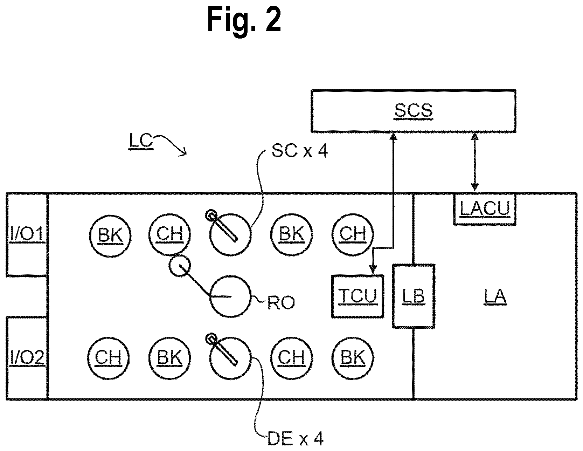

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

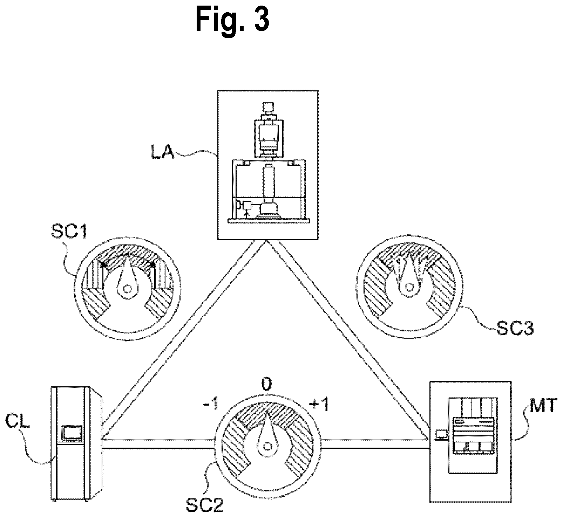

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Figure 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Figure 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Figure 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Figure 3 by the multiple arrows in the third scale SC3).

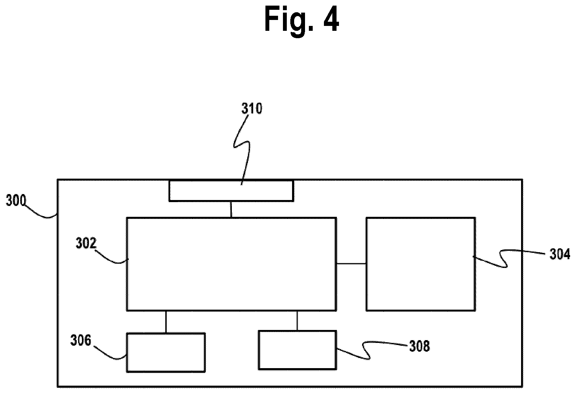

Figure 4 illustrates a simplified view of a computing device 300 suitable to perform the methods described herein. As shown in Figure 4, the computing device 300 comprises a central processing unit ("CPU") 302, to which is connected a memory 304. The functionality of the CPU 302 described herein may be implemented in code (software) stored on a memory (e.g. memory 304) comprising one or more storage media, and arranged for execution on a processor comprising on or more processing units. The storage media may be integrated into and/or separate from the CPU 302. The code is configured so as when fetched from the memory and executed on the processor to perform operations in line with embodiments discussed herein. Alternatively, it is not excluded that some or all of the functionality of the CPU 302 is implemented in dedicated hardware circuitry (e.g. ASIC(s), simple circuits, gates, logic, and/or configurable hardware circuitry like an FPGA).

The computing device 300 comprises an input device 306 to allow a user to input data. The input device 306 may comprise a keyboard, mouse, touchscreen, microphone etc. The computing device 300 further comprises an output device 308 to output data to the user. The output device 308 may comprise a display and/or a speaker. The computing device 300 may comprise a communications interface 310 for communication of data to and from the computing device 300.

The present disclosure describes a method for computing the deviation of a suspected faulty machine (a "subject production apparatus") from a reference population (at least one, and normally more than one) of reference machines ("other production apparatuses") which are assumed to operate properly. The faulty machine may comprise a plurality of modules. The population includes at least one reference machine, and typically includes a plurality of reference machines. The faulty machine and reference machines are of the same design, e.g. for each module of the faulty machine (referred to here as "type of module"), there is corresponding module of the reference machine. Each module of the faulty machine generally has the same dimensions, construction, operating parameters, etc. as the corresponding module of the reference machines.

In the case that the faulty machine is a lithographic apparatus, a module may be, for example, a lens or an airmount, but a module alternatively may be any other part of a production apparatus. The disclosed method comprises formulating the task of assessing a module deviation of a faulty machine as a supervised Machine Learning problem.

A machine learning model is a computational system, implemented either in software or hardware, which receives an input and performs one or more (typically many) non-linear functions on the input, based on adaptive parameter values of the model, to generate an output. The machine learning model may for example comprise a sequence of multiple layers of neurons: a first layer of neurons which receive the input, and one or more subsequent layers of neurons which each receive data generated by neurons in a preceding one of the layers. Each neuron may perform a non-linear function of the data it receives, based on a respective set of weights, which may be a subset of the adaptive parameter values. "Training" a machine learning model means iteratively adapting the parameter values of the machine learning model, so that a desired relationship is obtained between the input and the output of the model.

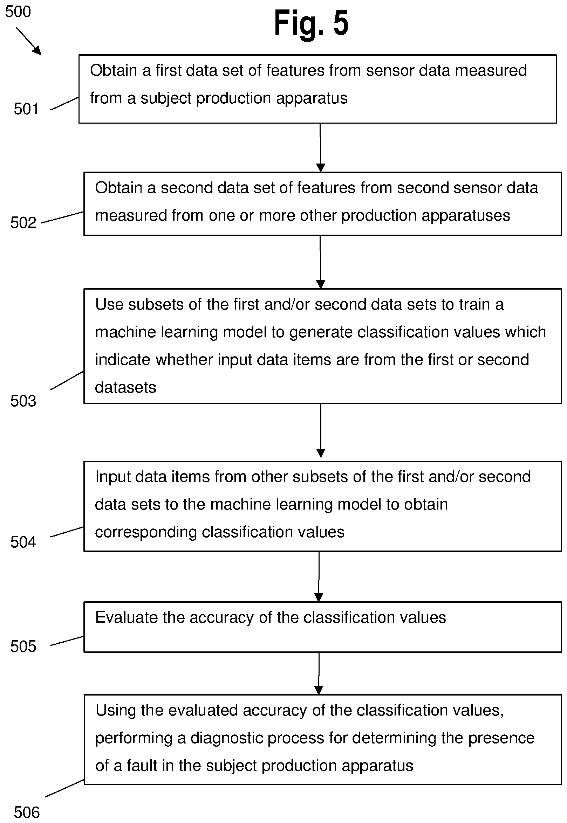

A method 500 according to the present invention is illustrated in Figure 5. The method may be performed using the computer system 300 of Figure 2. In a first step 501 a first data set is obtained. The first data set comprises features derived from first sensor data, which has been obtained by measurements from the faulty machine (subject production apparatus) using a first sensor. The first data set may comprise raw data (that is, the features may just be elements of sensor data generated by the first sensor), and/or may comprise features generated from the sensor data by a feature extraction process, such as statistical processing step(s) or an adaptive filter.

In step 502, a second data set is obtained of corresponding features derived from second sensor data measured from the reference machine(s) (other production apparatuses) of the population. The second sensor data may be measured by a respective second sensor for each of the other production apparatuses. Note that steps 501 and 502 may be performed in the opposite order or concurrently. Optionally, step 502 may be performed by reading the second data set from a database, such as a database generated much earlier, e.g. by a manufacturer of the production apparatus.

Note that the first and second data sets may include, or even consist of, time series. That is, for each of a sequence of times, the first data set may include a respective plurality of values representing features associated with that time (e.g. features derived from measurements at that time, or of a product produced at that time). Similarly, for each of another sequence of times, the second data set may include a respective plurality of values representing features associated with that time (e.g. features derived from measurements at that time, or of a product produced at that time). Indeed, the second data set may include such values for a corresponding sequence of times for each of the reference machines.

In step 503, a supervised learning technique is performed to train a machine learning model. The training is performed using a training dataset which includes a first subset of the first data set and a first subset of the second data set. The machine learning model is trained, upon receiving a data item (e.g. features associated with a certain time) which is randomly selected from the training data set, to generate (output) a classification value which indicates whether the input data item is an element of the first data set or the second data set.

In step 504, other data items from the first data set and/or second data set are input to the trained machine learning model. These data items are typically selected from a test set which is composed of different subsets of the first and second data sets than the first subsets (i.e. the machine learning model is tested using data items different from the training data). For each input data item, a corresponding classification value is output by the trained learning model.

In step 505, the accuracy of the classification values is evaluated.

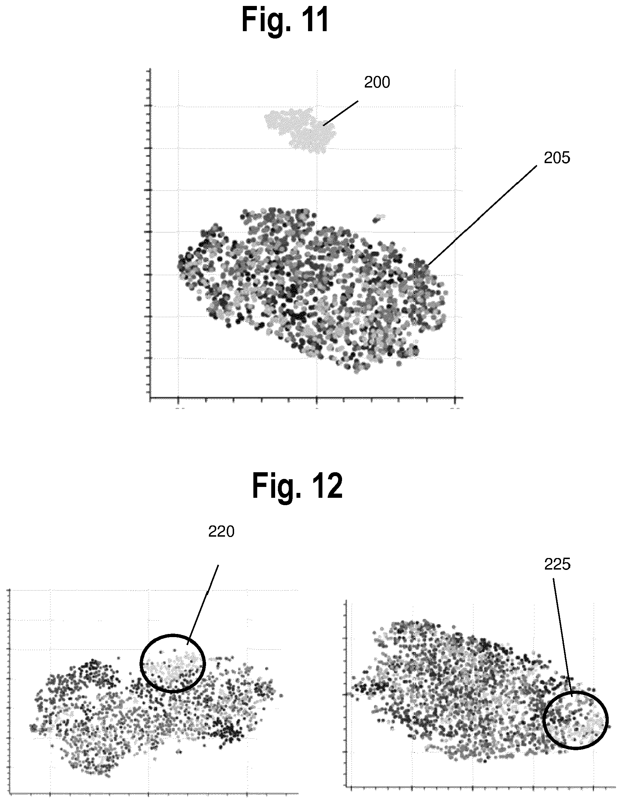

In step 506, the evaluated accuracy of the classification values is used to perform a diagnostic process for determining the presence of a fault in the subject production apparatus. For example, in this diagnostic process, it may be determined automatically from the evaluated accuracy whether to output an indication (e.g. an error message) to a user of the computing device 300 indicating that there is a fault with the subject production apparatus. This determination may be positive if the determined accuracy is above a threshold. In other words, the criterion which is used to determine to output the indication is that the machine learning algorithm is able to correctly distinguish data items of features derived from sensor data from the subject production apparatus, from data items of features derived from sensor data from the population of other production apparatuses. A machine learning system performs a complex function of the data items it receives, so the criterion which is used to perform the diagnosis is similarly sophisticated, as discussed below with reference to Figures 11 and 12.

In some case, the diagnostic process may include, or even consist of, displaying to a human expert (user) the evaluated accuracy for the subject production apparatus, or more usually respective evaluation accuracies for a plurality of modules of the subject production apparatus. The diagnostic process may further include receiving user input based on the displayed evaluated accuracy or accuracies.

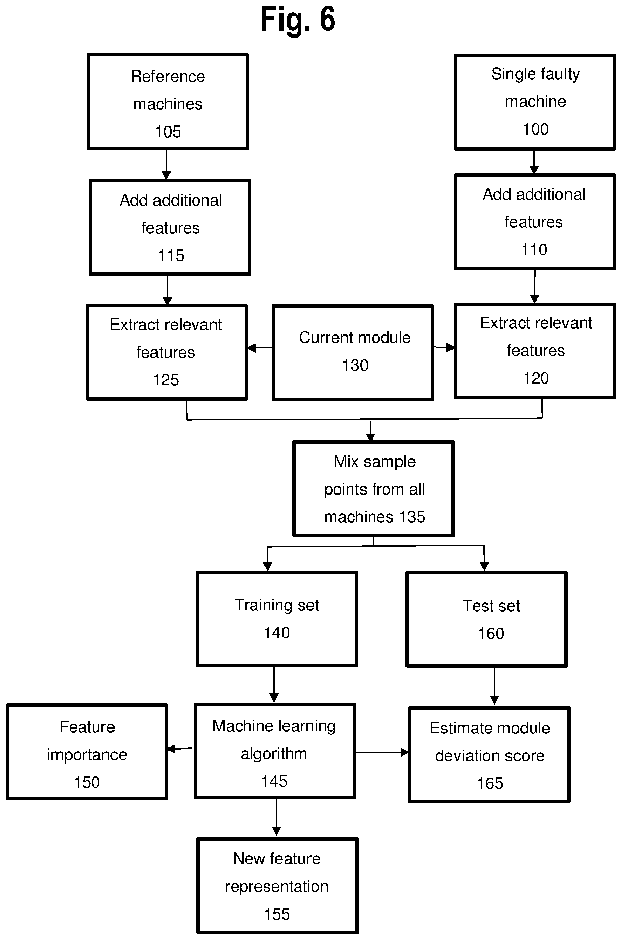

An example implementation of the method 500 is described with reference to Figure 6, which shows schematically the flow of data between units of a software application (e.g. running on the computer system 300 of Figure 2) which implements the example of the method 500.

In a first sub-step of step 501, first sensor data is obtained, comprising sensed data (a respective "first data set") for each of a plurality of modules of a faulty machine 100 (subject production apparatus), such as a lithographic apparatus. The first sensor data is derived from the subject production apparatus output by a first sensor which measures the modules of the subject production apparatus. The first sensor may contain multiple sensor elements arranged to measure sensor data from corresponding ones of the modules.

The measurement of data from a given module of the subject production apparatus may be conducted by the first sensor directly measuring the module and/or may be conducted by the first sensor measuring products of the subject production apparatus. For example, if a certain module of the subject production apparatus is responsible for forming one or more elements of a product of the subject production apparatus, the first sensor data for that module may comprise sensor data obtained by measuring that element of the product.

For each module, several properties may be measured, resulting in a high-dimensional measurement. The raw sensor data elements measured from the faulty machine 100 are examples of features of the first sensor data.

The first sensor data may comprise corresponding time-series data for some or all of the modules. The first sensor data may, for example, comprise (or consist of) data items which are corresponding sets of features relating to the faulty machine 100, where each set of features is associated with a respective time in a sequence of times.

Optionally, a software unit 110 derives additional features from the first sensor data and adds them to the corresponding first data sets. The additional features may comprise statistical aggregations of the first sensor data. For example, the additional features may comprise rolling means, or rolling standard deviations of the first sensor data. Derived features like rolling means and rolling standard deviations can provide additional predictive power to a machine learning model.

In addition to the derived features, entirely new features may also be added to the first sensor data. These features could be, for example, features indicating a time point at which the first sensor data is measured, or a position on a wafer of a sample where a part of the first sensor data is measured.

In a first sub-step of step 502, second sensor data is obtained from one or more other production apparatuses ("reference machines") 105 which are assumed to be normally working machines. Each reference machine 105 contains a set of modules corresponding to respective modules of the subject production apparatus 100 (i.e. each reference machine 105 contains every "type" of module). This second sensor data is used to form a corresponding second data set for each type of module. Preferably, the second data set for each type of module includes second sensor data from multiple reference machines 105. Acquiring second sensor data from more than one reference machine 105 has the advantage that the results of the method 500 are more reliable, because they represent acceptable variations between normally operating machines.

The second sensor data obtained from each reference machine 105 corresponds to the first sensor data obtained in step 501 from the subject production apparatus 100 (e.g. each element of data sensor data is sensed by the same type of sensor mechanism as a corresponding element of the first sensor data, from a module of the same type). Thus, the second sensor data in the second data set obtained for each of the reference machines 105 (other production apparatuses) comprises data from respective modules of those other production apparatuses which correspond to the plurality of modules of the faulty machine 100 for which the first data set contains first sensor data.

The second sensor data is derived by measuring the reference machines 105: either by direct measurements and/or measurements of products of the reference machines 105. As in the case of the first sensor data, for each module, several properties may be measured, resulting in a high-dimensional measurement. The raw sensor data measured from the plurality of reference machines 105 are examples of features of the second data set. The second sensor data, like the first sensor data, may comprise time-series data for one or more of modules. The second sensor data may, for example, comprise data items which are corresponding sets of features relating to one of the reference machines, where each set of features is associated with a respective time in a sequence of times.

In a next sub-step of step 502, a software unit 115 derives additional features from the second sensor data, and adds them to the corresponding second data sets. The additional features may comprise statistical aggregations of the sensor data. For example, the additional features may comprise rolling means, or rolling standard deviations of the second sensor data. In addition to derived features, entirely new features can be also added to the second data set. These features could be, for example, features indicating a time point or a position on a wafer of a sample at which the second sensor data is measured.

In this example implementation of the method 500, steps 503-505 are performed separately and successively for each type of module (as described below) using the software units 135, 145, 150, 155 and 165. Before that, the units 120, 125 and 130 divide the first sensor data and second sensor data into portions (respectively, first data sets and second data sets) relating to different ones of the modules.

Specifically, a software unit 130 successively picks one of the modules of the subject production machine (a "current module"). Each time it does this, a software unit 120 extracts the first data set relating to the current module of the subject production apparatus 100. Similarly, a software unit 125 extracts the second data set(s) relating to the current module of the reference machine(s) 105. Each of the first and second data sets is composed of data items associated with respective labels saying whether the data item is derived from the first sensor data or the second sensor data.

The first data set and the second data set are then combined by a software unit 135 to form a combined data set.

The combined data set is then divided into a training set 140 and a test set 160. Each of the training set 140 and the test set 160 include data items (that is, sets of the features) from both the first sensor data and second sensor data. It is to be understood that each data item for the current module has the same number of components whether it is derived from the first sensor data or the second data. A given data item may for example be a set of features derived from measuring the current module a given production apparatus (i.e. the subject production apparatus or one of the other production apparatuses) at a corresponding time and/or a product which that given production apparatus produced at that time.

Optionally, the combined data set may be divided into the training set 140 and test set 160 based upon time values associated with the data items. For example, data items having a time value indicating that they were associated with a time (e.g. measured at a time) before a threshold time may be allotted to the training set 140, and data items associated with a time at or after the threshold time may be used in the test data set 160. Alternatively, the data items of the training set may be associated with times interleaved with times associated with the data items of the test set.

A software unit 145 then performs a supervised learning process on a machine learning model, to train the machine learning model to be a classifier to classify the data items of the training set 140 (step 503). Specifically, the supervised learning trains the machine learning model, upon receiving a data item from the first or second data sets, to output a classification value indicative of whether the received data item is from the first or second data sets. The supervised learning process iteratively adapts numerical parameters of the machine learning model so that the classification value output upon the machine learning model receiving one of the data items corresponds to the corresponding label. That is, the classifier is used to determine whether a given set of features (data item) was derived from the faulty machine 100 (subject production apparatus) or a reference machine 105. The classification value may be "positive" to indicate that the data item is from the faulty machine 100, and "negative" to indicate that the data item is from a reference machine 105.

Note that before the features of the data items are input into the classifier, some or all of the features may be normalized (e.g. such that each feature is a numerical value in the range 0 to 1). The normalization may be applied per feature and/or per sample.

Any type of classifier may be used by the software unit 145 as the machine learning model. For example, the classifier may be a logistic regression classifier or a random forest classifier.

Once the classifier has been trained on the training data set, a software unit 160 inputs data items from the test set 150 to the trained classifier (step 504), and a software unit 165 evaluates the accuracy of the classifier (step 505). The evaluated accuracy may be referred to as the current module's "deviation score". The deviation score indicates how well the classifier performs on the test data set. A number of possible metrics may be used to generate a value for the evaluated accuracy. For example, the metric may be a simple accuracy metric (i.e. the proportion of the test set 160 for which the classifier outputs the correct classification value). Alternatively, it may be a metric such as a true positive rate (TPR). A TPR score is a type of performance metric in which only the accuracy of the positively predicted features is considered. TPR is preferably used for unbalanced datasets, as in the present example, since there is only a single faulty machine 100 of which the data items will cause the classifier to output positive values and preferably a plurality of reference machines 105 of which the data items will cause the classifier to output negative values. If the simple accuracy metric were to be used, a misleadingly high score could be achieved by a trivial classifier that always predicted negative values. The performance metric is used as a deviation score (evaluated accuracy). That is, if a feature is evaluated to contribute to an accurate classification of a positive value, that particular feature is deemed to correspond to a deviation in the current module of the faulty machine. A deviation score is calculated by the software unit 165 for the current module.

Optionally, a software unit 150 may interrogate the trained machine learning model (classifier) to determine, for each of the features of each data item, a respective importance parameter. This indicates the importance of the feature in determining classification values. Preferably, a classifier is used which, following the training, can be interrogated in this way. For example, the machine learning model may be a logistic regression classifier, and if so the importance parameter may be the magnitude of at least one feature coefficient of the logistic regression classifier (i.e. one or more weight values which are multiplied by a numerical value representing the feature, or a function of those weight value(s)). Alternatively, the machine learning model may be a random forest classifier, and if so the importance value may represent the ability of the given feature to decrease a class impurity of the classification.

Optionally, a software unit 155 may generate a weighted sum of the features of each data item weighted by their respective importance values. This gives a numerical "new feature representation", which is discussed below.

The software unit 130 then picks a new current module, and the process is repeated, until it has been carried out for all modules of the subject production apparatus.

In this way, the above steps of forming the training and test sets, training the classifier using the training data set, and evaluating the classifier using the test set are repeated for each module. When these steps have been repeated for each module, the respective deviation scores of each module can be inspected. Optionally, the deviation scores can be ranked to prioritize module inspections.

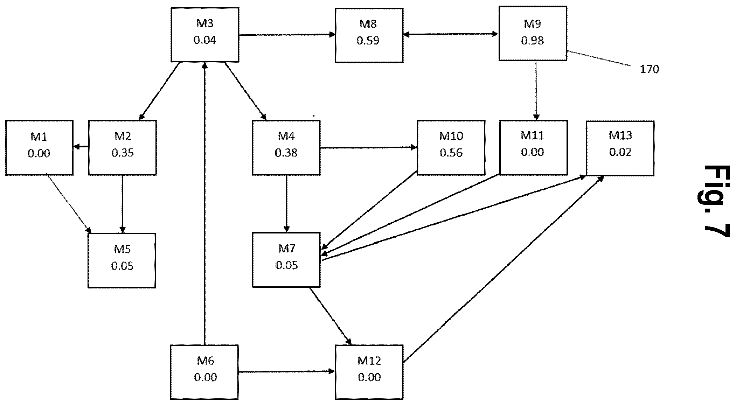

Figure 7 shows a screen shot of a first screen presented to the user by a user interface of the computer system 300. Each box in Figure 7 represents a respective one of the modules (labelled M1 to M13) of the subject production apparatus, and the value shown in the box is the deviation score for the corresponding module of the subject production apparatus. As can be seen, the highest deviation score (0.98) comes from the module M9, which is displayed in the box 170. This is indicative that the underlying problem in the faulty machine derives from a fault with the module M9.

A deep dive analysis may be performed by examining the importance of each individual feature for the classification outcome using the importance parameters output by the software unit 150. As noted above, the importance parameter is computed in a way which depends on the type of classifier. For example for a classifier which uses logistic regression, the feature importance parameter is the magnitude of the feature coefficients of the logistic classifier. On the other hand, for a random forest classifier, a feature's importance parameter reflects the ability of a feature to decrease a class impurity.

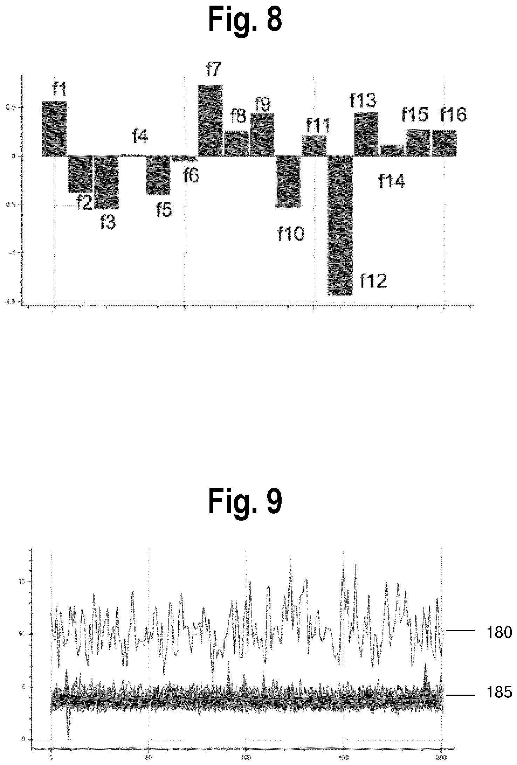

As an example, Figure 8 shows a screen shot of a second screen presented to the user by the user interface of the computer system 300. The graph in Figure 8 shows the feature importance parameters for the module M9 for a logistic regression classifier in the case that each data item for this module includes 16 features labelled f1 to f16. As can be seen, feature f12 is the importance parameter with the largest absolute value, and thus provides the largest contribution to the classification outcome, so the fault with the module M9 is likely to arise as a result of a fault with a physical property of the module M9 associated with the feature f12.

Using the feature importance parameter as an indication of a cause of a fault with a faulty machine, it is further possible to examine the feature values to determine whether there is a deviation identifiable by a human. Figure 9 shows a screen shot of a third screen presented to the user by the user interface of the computer system 300. The graph in Figure 9, which has a horizontal axis indicating advancing time, plots as the line 180 the values for the subject production apparatus 100 at a series of time points of the feature f12 (i.e. the feature having the highest importance parameter for the module M9). Similarly, the graph in Figure 9 plots as the line 185 the time series of the feature f12 for the reference machines 105. As can be seen, the data 180 relating to the module M9 of the subject production apparatus 100 deviates significantly from the data 185 relating to the modules M9 of the reference machines 105. This deviation is easily identified by a human user.

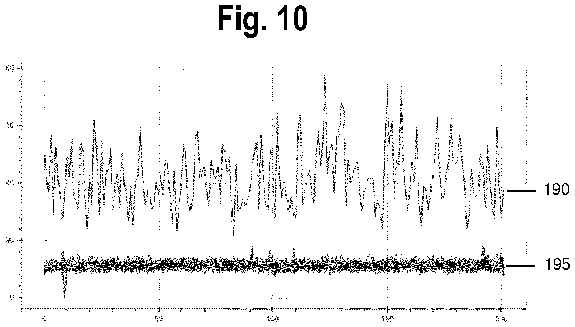

As noted above, optionally a software unit 155 of Figure 6 may be used to generate values for a new feature representation. Figure 10 shows a screen shot of a fourth screen presented to the user by the user interface of the computer system 300. The graph of Figure 10, which has a horizontal axis indicating advancing time, plots as the line 190 the values for the subject production apparatus 100 at a series of time points of the new feature representation generated by the software unit 155. Similarly, the graph in Figure 10 plots as the line 195 the time series of the new feature representation for the reference machines 105. Again, the data 195 relating to the module M9 of the subject production apparatus 100 deviates significantly from the data 195 relating to the modules M9 of the reference machines 105. Even in cases for which the deviation of the lines (such as lines 180 and 185) representing existing features are not well-separated, line (such as the lines 190 and 195) representing the values of the new feature representation may be well separated. This may additionally help in identifying problems with the current module.

Note that an advantage of implementing the method 500 as the process illustrated in Figure 6, which operates on each module of the subject production apparatus separately (e.g. trains a different machine learning model for each respective module of the subject production apparatus), rather than an alternative implementation of the method 500 in which a single machine learning model is trained to learn to distinguish all the first sensor data from all the second sensor data and respective importance parameters are derived for each of the modules, is that it means that amount of training data required by the supervised learning procedure is much reduced.

It is possible to repeat the process illustrated in Figure 6 with the software unit 145 using a different classifier of a different type, and/or with the software units 110, 115 generating different additional features. This allows for more information regarding the most likely underlying cause of deviation in a module to be obtained, thus improving the diagnosis process. For example, if a first iteration of the method may be performed using a logistic regression classifier, a second iteration of the method may be performed using a random forest classifier, or vice versa.

The deviation scores can be used as an indication of module deviation. In addition the importance parameters can help with identifying what features are contributing to the deviation of the module. The combination of the various pieces of information can help in identifying an underlying physical cause for the deviating behaviour of the machine.

In summary, this embodiment of the invention provides a computer-implemented tool that computes and visualizes the deviation scores for each module of a subject processing apparatus. Figures 7-10 are screenshots of a screen presented by the tool. Figure 7 shows the module deviation scores, and Figure 8 shows the feature importance values for a given module in such a way that it is possible to identify which features provide the most significant contribution to the deviation score. This tool makes it possible to identify deviating modules and features that are contributing towards the deviation. It is also possible to examine the features in a new feature space, using the screen shown in Figure 10. An additional benefit is that by examining the various metrics produced by the tool, valuable insight into the behaviour of the machine can be obtained. Using the procedure which is described here it is then possible to determine an underlying cause of the deviation.

The above disclosure provides numerous advantages over known methods of diagnosing a fault in a production apparatus.

Firstly, the method treats machine signals as multivariate time series data and as a result can be used to identify deviations in a high dimensional space (e.g. 16 dimensional in the case of Figure 8).

Furthermore, according to the method, one deviation score per module is computed, and the deviation scores across the plurality of modules of the machine are comparable. With the proposed methodology, deviations that contribute the most in separating the faulty machine from the healthy population can be prioritised when identifying a fault in the machine.

According to the method, the importance to the classification of the individual features of the sensor data is indicated, in order to enable a deep dive analysis.

Furthermore, the method does not require an assumption that the input signals are normally distributed. The method can also be successfully applied to small datasets.

The method is also advantageous in that it can be used to quantify not only large deviations but also borderline deviations of a suspect module. This sensitivity to small deviations is a great advantage over known methods because the abnormality of a module is defined with respect to its context (e.g. the deviation of other modules).

### COMPARATIVE EXAMPLES

To verify that the proposed method is advantageous over other techniques known in the prior art, the method was compared below with two known unsupervised techniques for determining a deviation in a suspect module.

The first known technique uses a one-class Support Vector Machine (SVM), and the second uses a Recurrent Neural Network (RNN) based auto-encoder. For each type of module in a population of reference machines, a respective machine learning model of each type was trained by unsupervised training. Then, the features of each module of a faulty machine were input to the two corresponding trained machine learning models. For the SVM model, the number of outlier data points were aggregated to one score, having a value of between 0 and 1, while for the auto-encoder model, reconstruction error was used as a deviation score. As a result, the scores of the auto-encoder model were not normalized from 0 to 1, but could still be qualitatively compared with the other approaches (wherein a reconstruction error tending towards 0 is indicative of there being no deviation, whilst a reconstruction error much greater than zero is indicative of a large deviation).

In Table 1 below, the first column lists the modules of each production apparatus. The results of using the machine learning models trained by unsupervised learning are shown in the second and third columns of Table 1 below. As mentioned above, the scores of the RNN auto-encoder shown in column three are not normalized from 0-1. For this machine they take values from 0 - 8.56. (Note that for modules 11 and 12 the one class SVM did not produce a result, so these two boxes of Table 1 do not contain a numerical value.)

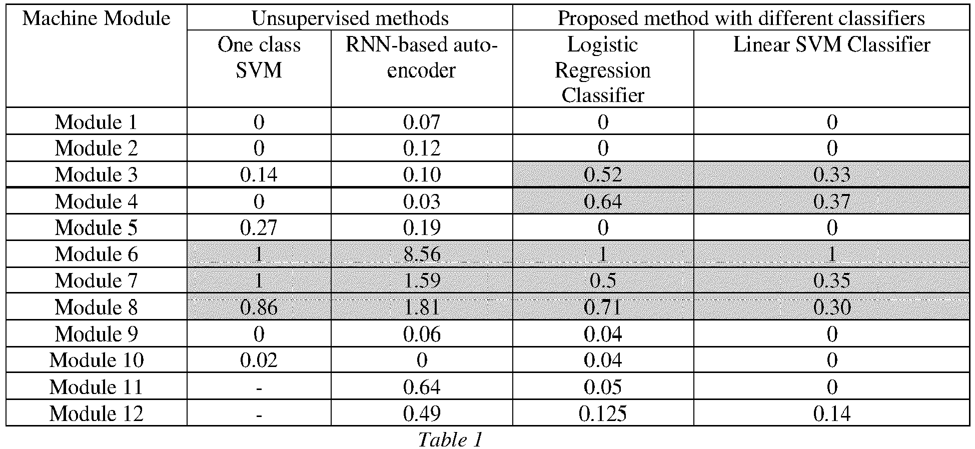

Columns four and five of Table 1 show, for each of the modules, the respective deviation score produced by the embodiment of Figure 6 in the case that the machine learning model is a logistic regression classifier (column 4) and a linear SVM classifier (column 5).

Shaded boxes represent modules for which the numerical values in Table 1 are elevated above a threshold (0.3 in the case of the second, fourth and fifth columns).

An expert machine diagnostics team also analysed the faulty machine, and determined that modules 3, 4, 6, 7 and 8 are faulty. As shown in Table 1, these five modules have high values of the deviation score for each of the two machine learning models used in the embodiment. Thus, the present embodiments correctly identified the faulty modules, and it appears that this identification is not dependent on any specific learning model being used.

By contrast, for the two known techniques, although modules 6, 7 and 8 were diagnosed as subject to a problem, the deviations for modules 3 and 4 were not identified, so a problem associated with these modules would not have been identified.

Considering module 6, Table 1 shows that all four methods agreed that the Module 6 is deviating, since the values that each approach assigns to Module 6 are relatively large (above the threshold).

Figure 11 is a two-dimensional representation of the sensor data of Module 6, where each point represents a particular sensor data measurement. The two axes in Figure 11 represent two respective features of the sensor data. The degree of shading for each point indicates the respective machine from which the corresponding sensor data was obtained. The sensor data for the faulty machine is shown by the points 200 (each of these points represents the faulty machine measured at a corresponding time and/or a measurement of a product of the faulty machine produced at the corresponding time), and the sensor data for the reference machines is shown by the points 205. In this case, the data points 200 for the faulty machine form a separate cluster from the data points 205, so it is possible to identify individual features of the faulty machine that deviate significant from the healthy population. The significant deviations can be identified by both the supervised model according to the present application, and the unsupervised models, as can be seen in Table 1.

The left and right portions of Figure 12, on the other hand, are two-dimensional representations of the sensor data of Modules 3 (right part) and 4 (left part). In each case again, the two axes in Figure 12 represent two respective features of the sensor data, and the degree of shading for each point indicates the respective machine from which the corresponding sensor data was obtained.

The data points which represent sensor data from the faulty machine are principally located in the regions 220 and 225. As can be seen, neither of the two features individually clearly deviates for either of these modules. However, looking at Table 1, it is notable that the deviation scores for Modules 3 and 4 obtained by the two supervised approaches of the embodiment demonstrated significant deviation. These deviations were not identified by the unsupervised approaches. The deviating behaviour in these two modules is a valuable indicator of overall machine misbehaviour, since the examined machine has two underlying causes that cause the deviation of the machine. The deviation shown in Figure 12 is less obvious than that shown in Figure 11. However, whilst the deviation shown in Figure 12 is a borderline deviation, it indicates a serious machine issue which is present in both Module 3 and Module 4.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include a tangible memory storage device such as read only memory (ROM); random access memory (RAM); magnetic storage media; optical storage media; flash memory devices. Alternatively, it may include electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method of diagnosing a fault in a subject production apparatus, the method comprising:
(a) obtaining a first data set and a second data set, wherein the first data set comprises a plurality of features derived from first sensor data measured from the subject production apparatus, and the second data set comprises a plurality of features derived from second sensor data measured from one or more other production apparatuses;
(b) performing supervised training of a machine learning model using a first subset of the first data set and a first subset of the second data set, wherein the machine learning model is trained, upon receiving a data item selectively from the first or second data sets, to output a classification value indicative of whether the received data item is from the first or second data sets;
(c) inputting a second subset of the first data set and/or a second subset of the second data set to the trained machine learning model to obtain corresponding classification values;
(d) evaluating the accuracy of the classification values; and
(e) using the evaluated accuracy of the classification values in performing a diagnostic process for determining the presence of a fault in the subject production apparatus.

2. A method according to claim 1, wherein each of the subject production apparatus and the one or more other production apparatuses comprises a plurality of corresponding modules, and the first and second subsets of both the first and second data sets comprise features derived from measurements made respectively of a first module of the subject production apparatus and corresponding modules of the other production apparatuses.

3. A method according to claim 2, wherein the plurality of features of the first dataset comprise statistical aggregations of the sensor measurements of the first module of the subject production apparatus, and the plurality of features of the second dataset comprise statistical aggregations of the measurements of the corresponding modules of the other production apparatuses.

4. A method according to claim 2 or claim 3, wherein the plurality of features of the first dataset comprise raw sensor data from the measurements of the first module of the subject production apparatus, and the plurality of features of the second dataset comprise raw sensor data from the measurements of the corresponding modules of the other production apparatuses.

5. A method according to any of claims 2 to 4, further comprising, for each of one or more other modules of the subject production apparatus, obtaining a respective additional first data set relating to that module of the subject production apparatus and a respective additional second data set relating to a corresponding modules of the other production apparatuses, and, for each of the other modules of the subject production apparatus, performing steps (b)-(d) using the corresponding additional first data set and additional second data set, and a corresponding machine learning model, to obtain a respective evaluation accuracy for each of the other modules.

6. A method according to claim 5, in which the diagnostic process comprises identifying a subset of the modules of the subject production apparatus for which the respective evaluation accuracies are highest, and providing an indication of the identified subset of modules to a user.

7. A method according to any preceding claim, wherein the diagnostic process comprises using the supervised machine learning algorithm to determine from each of a plurality of features of the first and second datasets a respective importance parameter indicative of the importance of the feature in determining the classification value, and identifying at least one of the features for which the importance parameter is highest.

8. A method according to claim 7, wherein the machine learning model is a logistic regression classifier, and wherein the importance parameter represents a magnitude of a feature coefficient of the logistic regression classifier.

9. A method according to claim 7, wherein the machine learning model is a random forest classifier, and wherein the importance parameter represents the ability of a feature to decrease a class impurity.

10. A method according to any preceding claim, wherein the production apparatus is a lithographic apparatus.

11. A computer system comprising a processor and a data storage device storing program instructions operative, when performed by the processor, to cause the processor to perform the steps of the method of any preceding claim.

12. A computer program product comprising instructions which, when the program is executed by a computer, cause the computer to carry out the steps of the method according to any of claims 1 to 10.

13. A computer-readable storage medium comprising instructions which, when executed by a computer, cause the computer to carry out the steps of the method according to any of claims 1 to 10.
